# EUROPÄISCHE PATENTSCHRIFT

(11) **EP 3 467 241 B1**
(45) Veröffentlichungstag und Bekanntmachung des Hinweises auf die Patenterteilung: **25.12.2019**
(21) Anmeldenummer: 18192397.0
(22) Anmeldetag: 04.09.2018
(51) Int. Cl.: E05B 81/76, E05B 85/10

(54) **VERFAHREN ZUM HERSTELLEN EINER GRIFFEINRICHTUNG SOWIE ENTSPRECHENDE GRIFFEINRICHTUNG**
METHOD FOR PRODUCING A GRIPPING DEVICE AND GRIPPING DEVICE
PROCÉDÉ DE FABRICATION D'UN DISPOSITIF POIGNÉE AINSI QUE DISPOSITIF POIGNÉE CORRESPONDANT

(30) Priorität: 04.10.2017 DE 102017123015
(43) Veröffentlichungstag der Anmeldung: 10.04.2019
(73) Patentinhaber: Huf Hülsbeck & Fürst GmbH & Co. KG, 42551 Velbert (DE)
(72) Erfinder: LÖW, Matthias, 40855 Ratingen (DE); BOCZEK, Artur, 42113 Wuppertal (DE); HERRMANN, Frank, 45139 Essen (DE)
(74) Vertreter: Zenz Patentanwälte Partnerschaft mbB

(56) Entgegenhaltungen:
- EP-A1- 2 899 340
- DE-A1-102009 009 396
- DE-A1-102010 060 378
- DE-A1-102015 116 153

## Beschreibung

Die vorliegende Erfindung betrifft ein Verfahren zum Herstellen einer Griffeinrichtung sowie eine entsprechende Griffeinrichtung.

Aus dem Stand der Technik sind Griffeinrichtungen bekannt, bei denen in einem innen gelegenen Aufnahmeraum Elektronik-Bauteile angeordnet sind. Um diese Elektronik-Bauteile vor Witterungseinflüssen zu schützen, sind diese Elektronik-Bauteile beispielsweise in einer Einhausung aus einer Dichtmasse angeordnet, wobei diese Einhausung im Zuge der Herstellung der Griffeinrichtung in dem Aufnahmeraum angeordnet wird. Aus dem Stand der Technik ist auch ein Verfahren zum Herstellen einer Griffeinrichtung bekannt, bei welchem die Elektronik-Bauteile in dem Aufnahmeraum angeordnet werden, dieser mit einer Dichtmasse vergossen wird und die Griffeinrichtung anschließend zusammengebaut wird. Bekannte Griffvorrichtungen und Verfahren zum Herstellen von Griffvorrichtungen sind z.B. in den Dokumenten DE 10 2010 060 378 A1 und DE 10 2009 009 396 A1 offenbart.

Nachteilig bei dem vorgenannten Verfahren ist es, dass die Zeit, die zum Herstellen einer Griffeinrichtung notwendig ist, relativ lang ist, da die Griffeinrichtung erst nach dem Aushärten der Dichtmasse zusammengebaut werden kann.

Es ist daher Aufgabe der vorliegenden Erfindung, ein Verfahren bereitzustellen, gemäß welchem Griffeinrichtungen mit vergossenen Elektronik-Bauteilen rasch hergestellt werden können. Es ist ferner Aufgabe der vorliegenden Erfindung, eine entsprechende Griffeinrichtung bereitzustellen.

Die vorliegende Aufgabe wird erfindungsgemäß gelöst durch ein Verfahren nach Anspruch 1. Erfindungsgemäß wird ein langgestreckter Handhaben-Grundkörper mit einem zentralen Aufnahmeraum bereitgestellt, in dem zentralen Aufnahmeraum auf einem Träger angeordnete Elektronik-Bauteile angeordnet, um den zentralen Aufnahmeraum eine diesen einfassende Dichtfuge auf dem langgestreckten Handhaben-Grundkörper aufgebracht und auf den langgestreckten Handhaben-Grundkörper eine passende Handhaben-Abdeckung aufgebracht.

Bei dem Aufbringen der Handhaben-Abdeckung wird die Dichtfuge derart komprimiert, dass der zentrale Aufnahmeraum über die Dichtfuge nach außen abgedichtet wird, und bei entgegengesetzten Enden des zentralen Aufnahmeraumes wird eine Einlassöffnung und eine Auslassöffnung gebildet. Der zentrale Aufnahmeraum ist also derart über die Dichtfuge abgedichtet, dass lediglich über die Einlassöffnung und die Auslassöffnung eine Fluid-Kommunikation mit einem Medium außerhalb des Aufnahmeraumes möglich ist. Der Aufnahmeraum wird durch Aufbringen der Handhaben-Abdeckung begrenzt bzw. abgeschlossen, der Aufnahmeraum vor dem Aufbringen der Handhaben-Abdeckung entspricht also nicht vollständig dem nach dem Aufbringen. Bei der vorliegenden Anmeldung wird für den offenen und geschlossenen Raum durchgehen der Begriff des Aufnahmeraums verwendet.

Die aus Handhaben-Grundkörper und Handhaben-Abdeckung zusammengefügte Griffeinrichtung wird sodann vertikal ausgerichtet, so dass die Einlassöffnung unten angeordnet ist, und über die Einlassöffnung wird eine flüssige Dichtmasse eingefüllt, die den zentralen Aufnahmeraum von unten nach oben füllt, wobei bei dem Einfüllen der flüssigen Dichtmasse in dem zentralen Aufnahmeraum vorhandene Gase über die Auslassöffnung abgeleitet werden. Nach dem Einfüllen der Dichtmasse lässt man diese aushärten, wobei dazu die Griffeinrichtung zumindest zu Beginn der Aushärtphase vorzugsweise vertikal ausgerichtet bleibt.

Das erfindungsgemäße Verfahren ermöglicht eine beschleunigte Herstellung der Griffeinrichtung, da diese sofort nach dem Zusammenfügen des Handhaben-Grundkörpers und der Handhaben-Abdeckung aufgrund der Bereitstellung der Dichtfuge von unten mit flüssiger Dichtmasse aufgefüllt werden kann. Die Dichtfuge verhindert ein Auslaufen der flüssigen Dichtmasse und ermöglicht es, dass die mit Dichtmasse aufgefüllte Griffeinrichtung sofort nach dem Befüllen mit Dichtmasse von der diesbezüglichen Arbeitsstation entfernt werden kann und eine weitere, noch nicht mit flüssiger Dichtmasse befüllte Griffeinrichtung verfüllt werden kann. Erfindungsgemäß ist es also nicht notwendig, auf die Aushärtung der flüssigen Dichtmasse zu warten, um das Äußere der Griffeinrichtung vollständig herzustellen.

Welche Dichtmasse genau verwendet wird, hängt vom jeweiligen Einzelfall ab. Diese muss in flüssigem Zustand verfüllbar sein und anschließend aushärten, die genaue Zusammensetzung ist abhängig von den verwendeten Materialien des Handhaben-Grundkörpers sowie der Handhaben-Abdeckung. Ferner kann das Gewicht sowie die Kosten der Dichtmasse bei der Auswahl der verwendeten Dichtmasse eine Rolle spielen. Für einen Fachmann ist die Auswahl einer für den Einsatzzweck passenden Dichtmasse eine übliche Übung.

Erfindungsgemäß werden bei entgegengesetzten Enden des Handhaben-Grundkörpers die Einlassöffnung sowie die Auslassöffnung ausgebildet, die die Fluid-Kommunikation des zentralen Aufnahmeraumes mit der Umgebung ermöglichen. Wie die Einlassöffnung und die Auslassöffnung ausgebildet werden, ist für die Erfindung unwesentlich, wesentlich ist, dass der Aufnahmeraum nach außen über die Dichtfuge abgedichtet und über die Einlass- und die Auslassöffnung eine Fluid-Kommunikation mit der Umgebung möglich ist. Die Einlass- und die Auslassöffnung können beispielsweise bei dem Zusammenfügen der Handhaben-Abdeckung und des Handhaben-Grundkörpers ausgebildet werden. So ist es denkbar, dass sowohl der Handhaben-Grundkörper als auch die Handhaben-Abdeckung zwei zum Beispiel halbkreisförmige Ausnehmungen aufweisen, die beim Zusammenfügen die Einlassöffnung und die Auslassöffnung ausbilden. Alternativ ist es denkbar, die Einlassöffnung und die Auslassöffnung sofort nach dem Zusammenfügen der Griffeinrichtung in den Handhaben-Grundkörper und/oder die Handhaben-Abdeckung einzubringen, beispielsweise durch eine Bohrung.

Die vorgenannten Möglichkeiten zur Einbringung der Einlassöffnung sowie der Auslassöffnung sind theoretisch denkbar, in der Praxis dürften solche Vorgehensweisen aber eher nicht relevant sein. Bei einer in der Praxis bevorzugten Ausführungsform, die konstruktiv besonders einfach ist, wird der langgestreckte Handhaben-Grundkörper mit zwei Öffnungen bereitgestellt, die beim Aufbringen der Handhaben-Abdeckung die Einlassöffnung und die Auslassöffnung bilden. Bei dem Aufbringen der Handhaben-Abdeckung ändern sich die Öffnungen als solche nicht, jedoch erlangen sie erst durch das Zusammenfügen der Handhaben-Abdeckung und des Handhaben-Grundkörpers bei Vorhandensein der Dichtfuge ihre Funktion der Einlassöffnung und der Auslassöffnung, da vor dem Zusammenfügen des Handhaben-Grundkörpers und der Handhaben-Abdeckung kein bis auf die Öffnungen geschlossener Aufnahmeraum vorliegt.

Durch Verwendung einer entsprechenden Dichtmasse ist es erfindungsgemäß möglich, den bis auf die Öffnungen geschlossenen Aufnahmeraum vollständig mit Dichtmasse auszufüllen. Aus fertigungstechnischen Gründen verhält es sich dabei so, dass die Dichtmasse stets an der Einlassöffnung anliegt. Bei genauer Dosierung der flüssigen Dichtmasse ist es möglich, den Hohlraum so zu verfüllen, dass die flüssige Dichtmasse nicht über die Auslassöffnung austritt, sondern nur bis kurz unter die Auslassöffnung reicht (der Aufnahmeraum wird von unten nach oben mit flüssiger Dichtmasse befüllt). Bei einer bevorzugten Ausführungsform ist es vorgesehen, dass die Einlassöffnung und/oder die Auslassöffnung nach dem Aushärten der flüssigen Dichtmasse mit einer Abdeckung versehen wird/werden. In Abhängigkeit davon, wie genau die Auslassöffnung ausgebildet ist, kann die Verwendung einer Abdeckung bei der Auslassöffnung unterbleiben. Aufgrund der Verfahrensführung kann es aus haptischen und optischen Gründen jedoch gewünscht sein, insbesondere die Einlassöffnung mit der vorgenannten Abdeckung zu versehen.

Um die Elektronik-Bauteile im Inneren der Griffeinrichtung gegen störende elektronische Einflüsse von außen abzuschirmen, ist es bei einer bevorzugten Ausführungsform vorgesehen, dass vor dem Aufbringen der Handhaben-Abdeckung eine Schutzblende über den Elektronik-Bauteilen angeordnet wird, wobei diese Schutzblende bei der fertigen Griffeinrichtung nach außen gerichtet ist und die Elektronik-Bauteile nach außen abschirmt.

Aus welchem Material die Dichtfuge gebildet ist, ist für die vorliegende Erfindung nicht wesentlich. Wesentlich ist vielmehr, dass über die Dichtfuge der zentrale Aufnahmeraum im Inneren der Griffeinrichtung (mit Ausnahme der Einlassöffnung und der Auslassöffnung) derart abgedichtet wird, dass die flüssige Dichtmasse von unten eingefüllt werden kann. Beispielsweise ist es denkbar, dass die Dichtfuge mit einer Dichtmasse auf der Basis von Polyurethan bereitgestellt wird. Derartige Dichtmassen haben eine Reihe von Vorteilen, sie weisen lediglich eine Komponente auf, sind elastisch, geruchsarm, nicht korrosiv, zeigen ein breites Haftspektrum und sind darüber hinaus lösemittelfrei. Durch eine chemische Anpassung der Dichtmasse auf Polyurethanbasis kann diese darüber hinaus an den speziellen Anwendungszweck angepasst werden, beispielsweise an die Materialien, die für den Handhaben-Grundkörper sowie die Handhaben-Abdeckung verwendet werden.

Die vorliegende Erfindung betrifft ferner eine Griffeinrichtung für ein Kraftfahrzeug mit einem langgestreckten Handhaben-Grundkörper und einer Handhaben-Abdeckung, wobei zwischen Handhaben-Grundkörper und Handhaben-Abdeckung eine Dichtfuge angeordnet ist, die mit dem Handhaben-Grundkörper und der Handhaben-Abdeckung einen zentralen abgeschlossenen Aufnahmeraum definiert, wobei in dem Aufnahmeraum auf einem Träger angeordnete Elektronik-Bauteile und Dichtmasse angeordnet sind und wobei der Aufnahmeraum bei gegenüberliegenden Enden eine Einlassöffnung und eine Auslassöffnung aufweist, die zumindest abschnittsweise mit Dichtmasse aufgefüllt sein können. Die Dichtmasse schützt die Elektronik-Bauteile in dem Aufnahmeraum vor Umwelteinflüssen und trägt ferner dazu bei, diese in der Griffeinrichtung bzw. dem Aufnahmeraum zu fixieren. Die erfindungsgemäße Griffeinrichtung ist beispielsweise nach dem oben genannten Verfahren herstellbar.

Bei einer bevorzugten Ausführungsform der erfindungsgemäßen Griffeinrichtung weist der Handhaben-Grundkörper die Einlassöffnung und/oder die Auslassöffnung auf. Diese bevorzugte Ausführungsform kann nach dem oben beschriebenen Verfahren am schnellsten mit den wenigsten Arbeitsschritten hergestellt werden. Würde man beispielsweise die Einlass- und/oder Auslassöffnung in der Handhaben-Abdeckung bereitstellen, sind nach dem Verfüllen der Griffeinrichtung mit Dichtmasse ggf. weitere Arbeitsschritte notwendig, um die Öffnungen vor einem Benutzer zu verbergen.

Das oben beschriebene Verfahren, welches beispielsweise zum Herstellen der Griffeinrichtung verwendet werden kann, bedingt es, dass zumindest die Einlassöffnung nach Fertigstellung der Griffeinrichtung mit Dichtmasse verfüllt ist. Aus haptischen und/oder optischen Erwägungen ist es bei einer bevorzugten Ausführungsform vorgesehen, dass die Einlass- und/oder Auslassöffnung mit einer Abdeckung versehen ist/sind.

Um die in dem Aufnahmeraum angeordneten Elektronik-Bauteile elektronisch abzuschirmen ist es bei einer bevorzugten Ausführungsform vorgesehen, dass in dem abgedichteten zentralen Aufnahmeraum über dem Träger mit Elektronik-Bauteilen eine Schutzblende angeordnet ist.

Bei einer bevorzugten Ausführungsform, die das Positionieren und Fixieren der Dichtfuge vor dem Zusammenfügen des Handhaben-Grundkörpers und der Handhaben-Abdeckung unterstützt, sind bei dem Umfang des Handhaben-Grundkörpers eine Mehrzahl von Vertiefungen angeordnet, in welche sich die Dichtfuge erstreckt.

Im Nachfolgenden wird eine bevorzugte Ausführungsform des erdfindungsgemäßen Verfahrens sowie eine bevorzugte Ausführungsform der erfindungsgemäßen Griffeinrichtung unter Bezugnahme auf die Zeichnung näher beschrieben, in welcher
Figuren 1a und 1b Schrägansichten einer Ausführungsform der erfindungsgemäßen Griffeinrichtung zeigen,
Figuren 2 - 6 verschiedene Schrägansichten des Handhaben-Grundkörpers ohne aufgebrachte Handhaben-Abdeckung bei verschiedenen Verfahrensschritten zeigen,
Figur 7 eine Seitenansicht der Griffeinrichtung vor dem Verfüllen mit flüssiger Dichtmasse zeigt, und
Figur 8 eine Schnittansicht der Griffeinrichtung beim Verfüllen mit flüssiger Dichtmasse zeigt.

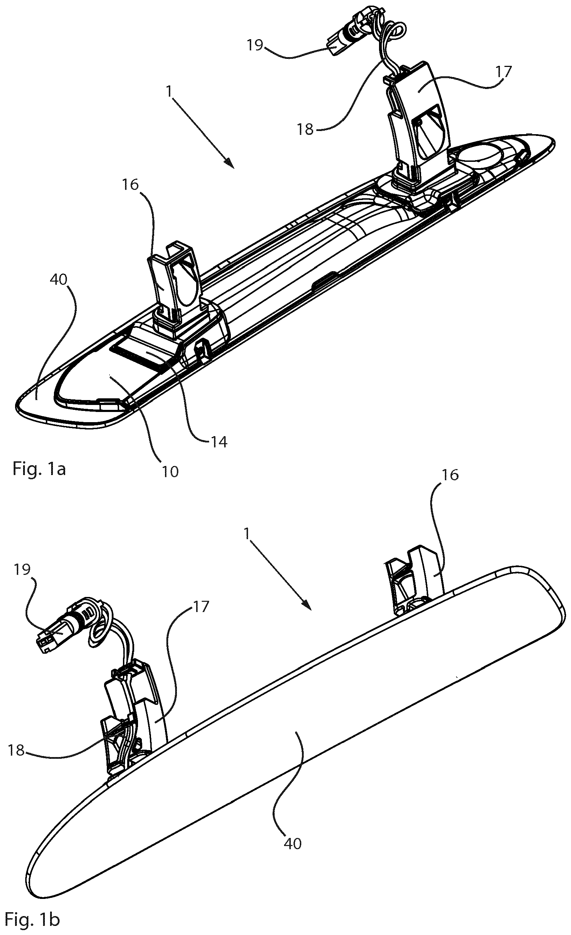

Figuren 1a und 1b zeigen Schrägansichten einer bevorzugten Ausführungsform der erfindungsgemäßen Griffeinrichtung 1. Bei der bevorzugten Ausführungsform umfasst die Griffeinrichtung einen Handhaben-Grundkörper 10 sowie eine Handhaben-Abdeckung 40, wobei die Handhaben-Abdeckung 40 an dem Handhaben-Grundkörper 10 befestigt ist. Figur 1b zeigt die Handhaben-Abdeckung 40 von außen, das heißt so, wie sie einem Benutzer entgegentritt, wobei die genaue Ausgestaltung der Handhaben-Abdeckung hinsichtlich ihrer Optik und/oder Form von dem genauen Anwendungsgebiet abhängig ist. Ein Anwendungsgebiet ist beispielsweise, die Griffeinrichtung in Türen eines Kraftfahrzeuges zu verbauen, und in einem solchen Fall hängt die Form und/oder die Farbe der Oberfläche der Handhaben-Abdeckung von der Farbe und dem Design des Kraftfahrzeuges ab.

Bei Figur 1a ist die Rückseite der Griffeinrichtung mit zwei Befestigungsmitteln 16, 17 gezeigt, mit welchen die Griffeinrichtung beispielsweise an bzw. in einer Tür eines Kraftfahrzeuges festgelegt ist. In Abhängigkeit von der genauen Ausgestaltung der Griffeinrichtung kann diese über die Befestigungsmittel 16, 17 derart in der Tür des Kraftfahrzeuges festgelegt sein, dass die Griffeinrichtung schwenkbar ist, also für den Benutzer klassisch nach oben geschwenkt werden kann. Bei alternativen Ausführungsformen ist diese einfach nur hintergreifbar, wozu eine entsprechende Ausnehmung in der Tür des Kraftfahrzeuges vorgesehen ist. Aus dem rechten Befestigungsmittel sind Leitungen 18 herausgeführt, an deren Ende ein Stecker 19 angeordnet ist, über welchen die Griffeinrichtung beispielsweise mit einer zentralen Steuereinrichtung des Kraftfahrzeuges verbunden werden kann.

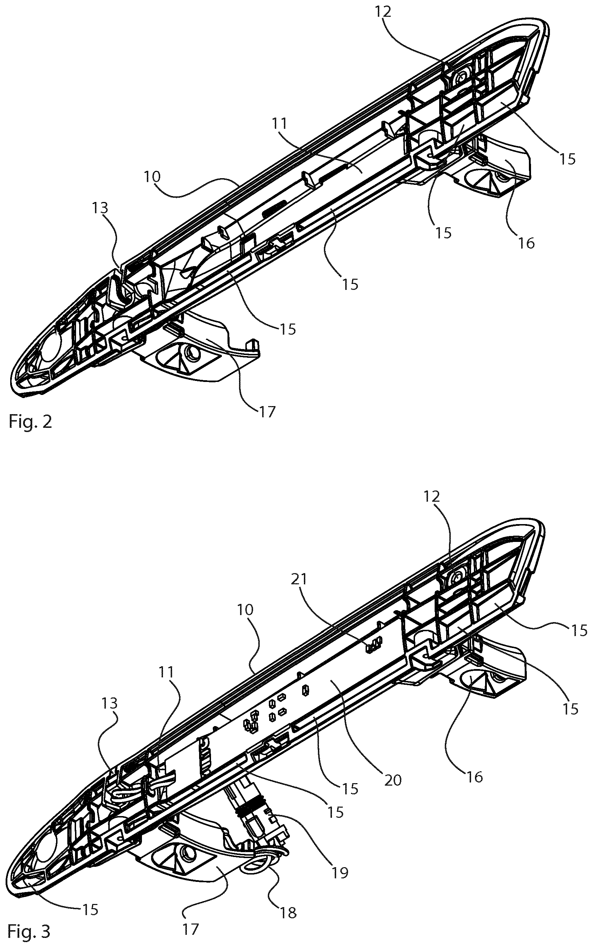

Figur 2 zeigt eine Schrägansicht des Handhaben-Grundkörpers, wobei im mittleren Bereich des Handhaben-Grundkörpers ein zentraler Aufnahmeraum 11 ausgebildet ist. Im rechten Abschnitt des Gehäuses des Handhaben-Grundkörpers ist eine Einlassöffnung 12 vorgesehen, über welche später eine Dichtmasse in die Griffeinrichtung eingeleitet werden kann. Bei der "linken" Seite von Figur 2 ist eine Auslassöffnung 13 zu erkennen, die bei der gezeigten Ausführungsform ferner dazu vorgesehen ist, Leitungen aus dem Inneren der Griffeinrichtung zu führen (die entsprechenden Leitungen waren in Figuren 1a und 1b zu erkennen). Figur 2 gibt den ersten Verfahrensschritt einer bevorzugten Ausführungsform des erfindungsgemäßen Verfahrens wieder, nämlich dass ein Handhaben-Grundkörper 10 bereitgestellt wird.

Figur 3 zeigt eine weitere Schrägansicht des Handhaben-Grundkörpers, wobei in dem Aufnahmeraum 11 ein Träger 20 mit einer Mehrzahl von Elektronik-Bauteilen 21 angeordnet ist. Der Träger ist über Leitungen 18 mit einem Stecker 19 verbunden. Die Leitungen 18 werden bei einer Auslassöffnung 13 aus dem Handhaben-Grundkörper hinausgeführt, wobei durch das Herausführungen der Leitungen die Auslassöffnung nicht vollständig verschlossen ist. Figur 3 zeigt die Situation nach dem zweiten Verfahrensschritt, nachdem der Träger 20 mit den Elektronik-Bauteilen in dem Aufnahmeraum 11 angeordnet ist.

Bei den Figuren 2 und 3 sind am Umfang des Handhaben-Grundkörpers mehrere Vertiefungen 15 zu erkennen. Diese Vertiefungen dienen dazu, wie dies in den nachfolgenden Figuren beschrieben ist, die Dichtfuge aufzunehmen und zu fixieren.

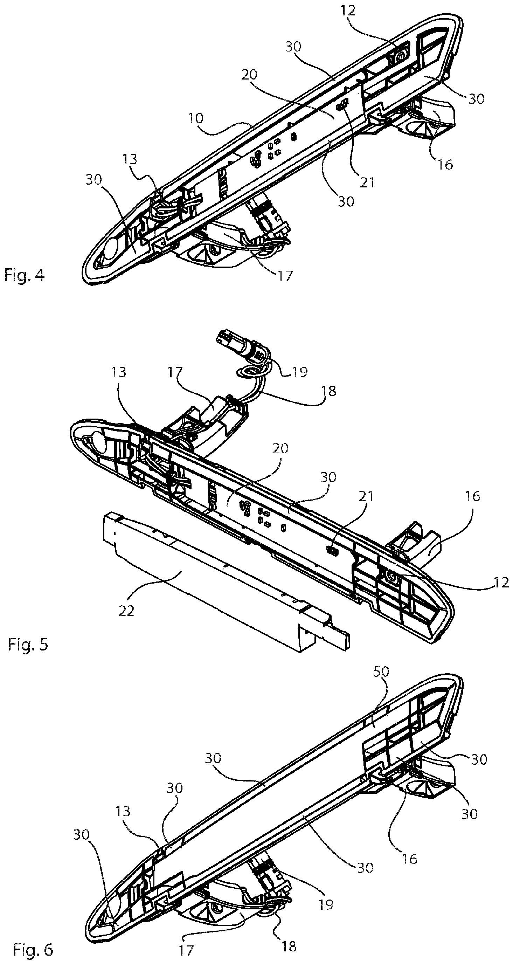

Figur 4 zeigt den Handhaben-Grundkörper mit einer aufgebrachten Dichtfuge 30, die sich am Umfang des Handhaben-Grundkörpers 10 erstreckt. Bei der gezeigten Ausführungsform erstreckt sich die Dichtfuge nicht an dem gesamten Außenumfang des Handhaben-Grundköpers, einige Stellen sind freigelassen. Bei diesen Stellen kann eine Verrastung mit der Handhaben-Abdeckung stattfinden. Auch diese Stellen können bei einer alternativen Ausführungsform mit der Dichtfuge belegt sein. Unabhängig davon, ob diese "Freistellen" vorhanden sind, bildet sich bei dem Aufbringen der Handhaben-Abdeckung ein bis auf die Öffnungen abgedichteter Aufnahmeraum.

Nachdem die Dichtfuge auf den Handhaben-Grundkörper aufgebracht ist, wird auf den Handhaben-Grundkörper die Handhaben-Abdeckung 40 aufgebracht, wobei nach dem Aufbringen der Handhaben-Abdeckung die Griffeinrichtung äußerlich fertiggestellt ist. Bei dem Aufbringen der Handhaben-Abdeckung wird die Dichtfuge zwischen dem Handhaben-Grundkörper und der Handhaben-Abdeckung komprimiert und der zentrale Aufnahmeraum 11, in welchem der Träger mit der Mehrzahl von Elektronik-Bauteilen 21 angeordnet ist, wird über die Dichtfuge nach außen abgedichtet. Mit anderen Worten wird bei dem Zusammenfügen des Handhaben-Grundkörpers 10 und der Handhaben-Abdeckung 40 mittels der Dichtfuge ein Art Hohlraum gebildet, der aufgrund der Bereitstellung der Einlass- und der Auslassöffnung 12, 13 in dem Handhaben-Grundkörper mit der Umgebung in Fluid-Kommunikation steht. Über die Dichtfuge sind die beiden Fügeteile Handhaben-Grundkörper und Handhaben-Abdeckung miteinander verbunden, gleichzeitig sorgt die Dichtmasse dafür, dass das Innere derart nach außen abgedichtet ist, dass lediglich über die Einlass- und die Auslassöffnung eine Fluid-Kommunikation mit der Umgebung möglich ist. Bei der hier beschriebenen bevorzugten Ausführungsform wird vor dem Zusammenfügen des Handhaben-Grundkörpers und der Handhaben-Abdeckung in dem Aufnahmeraum 11 noch eine Schutzblende 22 eingebracht, die die Elektronik-Bauteile im Inneren der späteren Griffeinrichtung vor elektronischen Außeneinwirkungen schützt. In Figur 5 ist die Schutzblende 22 kurz vor dem Aufbringen auf den Träger 20 mit den Elektronik-Bauteilen 21 dargestellt.

Figur 6 zeigt die fertige, mit Dichtmasse verfüllte Griffeinrichtung, wobei zur Veranschaulichung des Inneren der Griffeinrichtung die Handhaben-Abdeckung fortgelassen wurde. Am Außenumfang des Handhaben-Grundkörpers ist zu erkennen, dass die Dichtfuge komprimiert ist, wobei durch die Komprimierung die in den Figuren 2 und 3 erkennbaren Vertiefungen 15 wiedererkennbar sind. Dies bedeutet aber nicht, dass zwischen den einzelnen Vertiefungen 15 keine Dichtfuge angeordnet ist, sondern lediglich, dass die Dichtfuge in diesen Bereichen dünner ist bzw. sein kann. Zu erkennen ist, dass sich von der Einlassöffnung, die in Figur 6 durch Dichtmasse 50 verborgen ist, Dichtmasse 50 bis kurz vor die Auslassöffnung 13 erstreckt, das Innere der Griffeinrichtung also im Wesentlichen vollumfänglich mit Dichtmasse ausgefüllt ist. Welche Menge an Dichtmasse dazu notwendig ist, hängt von der genauen Ausgestaltung der Griffeinrichtung und der im Inneren der Griffeinrichtung angeordneten Bauelemente ab.

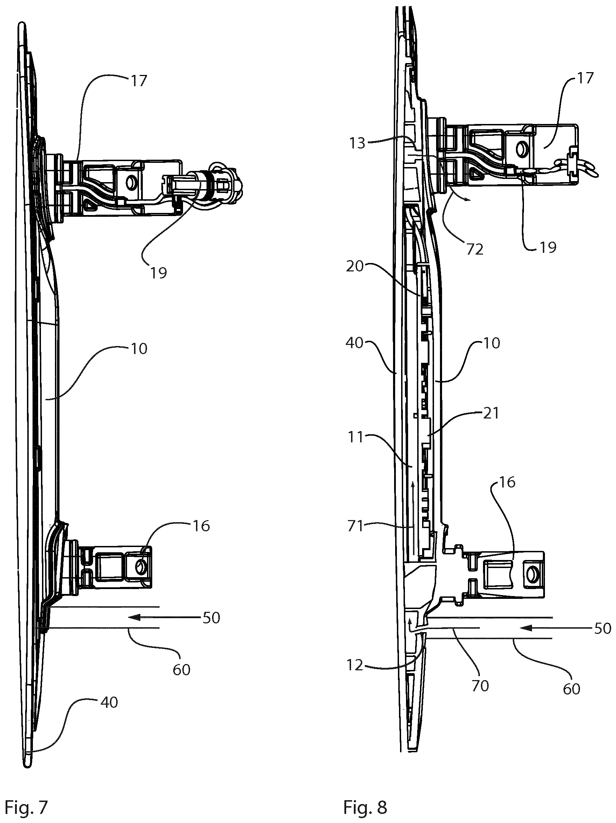

In Figur 7 ist die erfindungsgemäße Griffeinrichtung vertikal ausgerichtet dargestellt, wobei die Einlassöffnung 12 im unteren Abschnitt angeordnet ist. Bei Figur 7 ist schematisch eine Dichtmittelleitung 60 angedeutet, die mit der Einlassöffnung 12 zum Einfüllen flüssiger Dichtmasse gekoppelt ist.

Figur 8 zeigt eine Schnittansicht der vertikal ausgerichteten Griffeinrichtung. Figur 8 soll verdeutlichen, dass die Griffeinrichtung erfindungsgemäß von unten mit flüssiger Dichtmasse 50 verfüllt wird. Diese tritt unten über die Einlasseinrichtung 12 in die Griffeinrichtung ein, wie dies der Pfeil 70 andeutet. Mit fortschreitendem Einfüllen von flüssiger Dichtmasse steigt der Pegel der Dichtmasse innerhalb der Griffeinrichtung immer weiter an, was durch den Pfeil 71 verdeutlicht ist. Während des Einfüllens der flüssigen Dichtmasse tritt über die Auslassöffnung 13, die im oberen Bereich der Griffeinrichtung angeordnet ist, das in der Griffeinrichtung befindliche Gas aus, was über den Pfeil 72 veranschaulicht ist. Welches Gas aus der Griffeinrichtung austritt, ist abhängig davon, in welcher Atmosphäre die Herstellung der Griffeinrichtung genau ausgeführt wird.

Sobald die Griffeinrichtung ausreichend mit flüssiger Dichtmasse versehen ist, wird die Zufuhr dieser gestoppt und die Dichtmittelzuführung 60 entfernt. Sofern zu diesem Zeitpunkt die in der Einlassöffnung 12 befindliche Dichtmasse noch nicht ausgehärtet ist, muss mit dem Entfernen der Dichtmittelzuführung 60 ein Verschluss der Einlassöffnung 12 einhergehen. Alternativ kann die Griffeinrichtung bei entsprechender Anordnung der Einlass- und Auslassöffnung so lange waagerecht gelagert werden bis die Dichtmasse ausgehärtet ist.

Nach dem Aushärten der Dichtmasse kann die Einlassöffnung und die Auslassöffnung mit einer Abdeckung versehen werden, um diese haptisch und optisch zu verbergen. Um zu vermeiden, dass aus der Auslassöffnung 13 Dichtmasse austritt, wird regelmäßig nur so viel Dichtmasse eingefüllt, wie es eine vollständige Versiegelung der Elektronik-Bauteile sowie eine Fixierung dieser im Inneren der Griffeinrichtung erforderlich macht.

## Patentansprüche

1. Verfahren zum Herstellen einer Griffeinrichtung (1) für ein Kraftfahrzeug, wobei
ein langgestreckter Handhaben-Grundkörper (10) mit einem zentralen Aufnahmeraum (11) bereitgestellt wird,
in dem zentralen Aufnahmeraum (11) auf einem Träger (20) angeordnete Elektronik-Bauteile (21) angeordnet werden,
um den zentralen Aufnahmeraum (11) eine diesen einfassende Dichtfuge (30) auf dem langestreckten Handhaben-Grundkörper (10) aufgebracht wird,
auf den langegestreckten Handhaben-Grundkörper (10) eine passende Handhaben-Abdeckung (40) aufgebracht wird,
wobei bei Aufbringen der Handhaben-Abdeckung (40) die Dichtfuge (30) derart komprimiert wird, dass der zentrale Aufnahmeraum (11) über die Dichtfuge (30) nach außen abgedichtet wird, und bei entgegengesetzten Enden des zentralen Aufnahmeraums (11) wird eine Einlassöffnung (12) und eine Auslassöffnung (13) gebildet,
die Griffeinrichtung (1) vertikal ausgerichtet wird, so dass die Einlassöffnung (12) unten angeordnet ist,
über die Einlassöffnung (12) eine flüssige Dichtmasse (50) eingefüllt wird und den zentralen Aufnahmeraum (11) von unten nach oben füllt,
bei dem Einfüllen der Dichtmasse (50) in dem zentralen Aufnahmeraum (11) vorhandene Gase über die Auslassöffnung (13) abgeleitet werden.

2. Verfahren zum Herstellen einer Griffeinrichtung (1) für ein Kraftfahrzeug nach Anspruch 1, **dadurch gekennzeichnet, dass** der langgestreckte Handhaben-Grundkörper (10) mit zwei Öffnungen bereitgestellt wird, die beim Aufbringen der Handhaben-Abdeckung (40) die Einlassöffnung (12) und die Auslassöffnung (13) bilden.

3. Verfahren zum Herstellen einer Griffeinrichtung (1) für ein Kraftfahrzeug nach Anspruch 1 oder 2, **dadurch gekennzeichnet, dass** die Einlassöffnung (12) und/oder die Auslassöffnung (13) nach dem Aushärten der Dichtmasse (50) mit einer Abdeckung (14) versehen werden.

4. Verfahren zum Herstellen einer Griffeinrichtung (1) nach einem der Ansprüche 1 - 3, **dadurch gekennzeichnet, dass** vor dem Aufbringen der Handhaben-Abdeckung (40) eine Schutzblende (22) über den Elektronik-Bauteilen (21) angeordnet wird.

5. Griffeinrichtung (1) für ein Kraftfahrzeug mit
einem langestreckten Handhaben-Grundkörper (10) und einer Handhaben-Abdeckung (40), wobei zwischen Handhaben-Grundkörper (10) und Handhaben-Abdeckung (40) eine Dichtfuge (30) angeordnet ist, die mit dem Handhaben-Grundkörper (10) und der Handhaben-Abdeckung (40) einen zentralen abgeschlossenen Aufnahmeraum (11) definiert,
wobei in dem Aufnahmeraum (11) auf einem Träger (20) angeordnete Elektronik-Bauteile (21) und Dichtmasse (50) angeordnet sind und wobei der Aufnahmeraum (11) bei gegenüberliegenden Enden eine Einlassöffnung (12) und eine Auslassöffnung (13) aufweist, die zumindest abschnittsweise mit Dichtmasse aufgefüllt sein können.

6. Griffeinrichtung (1) für ein Kraftfahrzeug nach Anspruch 5, **dadurch gekennzeichnet, dass** der Handhaben-Grundkörper (10) die Einlassöffnung (12) und/oder die Auslassöffnung (13) aufweist.

7. Griffeinrichtung (1) für ein Kraftfahrzeug nach Anspruch 5 oder 6, **dadurch gekennzeichnet, dass** die Einlassöffnung (12) und/oder die Auslassöffnung (13) mit einer Abdeckung (14) versehen sind.

8. Griffeinrichtung (1) für ein Kraftfahrzeug nach einem der Ansprüche 5 - 7, **dadurch gekennzeichnet, dass** in dem abgedichteten zentralen Aufnahmeraum (11) über dem Träger (20) mit Elektronik-Bauteilen (21) eine Schutzblende (22) angeordnet ist.

9. Griffeinrichtung (1) für ein Kraftfahrzeug nach einem der Ansprüche 5 - 8, **dadurch gekennzeichnet, dass** der Handhaben-Grundköper (10) bei seinem Umfang eine Mehrzahl von Vertiefungen (15) aufweist, in welche sich die Dichtfuge (30) erstreckt.

## Claims

1. A method for producing a gripping device (1) for a motor vehicle, wherein
an elongated handling base body (10) is provided with a central receiving space (11),
in which central receiving space (11) electronic components (21) arranged on a support (20) are arranged,
around which central receiving space (11) a sealing joint (30) enclosing said receiving space is applied on the elongated handling base body (10),
on which elongated handling base body (10) a matching handling cover (40) is applied,
wherein the sealing joint (30) is compressed when applying the handling cover (40) such that the central receiving space (11) is sealed off to the outside via the sealing joint (30), and an inlet opening (12) and an outlet opening (13) are formed at opposite ends of the central receiving space (11),
the gripping device (1) is oriented vertically, such that the inlet opening (12) is arranged at the bottom,
via which inlet opening (12) a liquid sealing mass (50) is poured in and fills the central receiving space (11) from the bottom to the top,
in the case of which filling of the sealing mass (50) in the central receiving space (11) gases which are present are conducted away via the outlet opening (13) .

2. The method for producing a gripping device (1) for a motor vehicle according to Claim 1, **characterized in that** the elongated handling base body (10) is provided with two openings, which form the inlet opening (12) and the outlet opening (13) when applying the handling cover (40).

3. The method for producing a gripping device (1) for a motor vehicle according to Claim 1 or 2, **characterized in that** the inlet opening (12) and/or the outlet opening (13) are provided with a cover (14) after the sealing mass (50) is cured.

4. The method for producing a gripping device (1) according to one of Claims 1 - 3, **characterized in that** a shield (22) is arranged over the electronic components (21) before applying the handling cover (40) .

5. A gripping device (1) for a motor vehicle having
an elongated handling base body (10) and a handling cover (40), wherein a sealing joint (30) is arranged between the handling base body (10) and handling cover (40), which sealing joint defines a centrally closed receiving space (11) with the handling base body (10) and the handling cover (40),
wherein electronic components (21), arranged on a support (20), and sealing mass (50) are arranged in the receiving space (11) and wherein the receiving space (11) has an inlet opening (12) and an outlet opening (13) at opposite ends, which openings can at least partially be filled with sealing mass.

6. The gripping device (1) for a motor vehicle according to Claim 5, **characterized in that** the handling base body (10) has the inlet opening (12) and/or the outlet opening (13).

7. The gripping device (1) for a motor vehicle according to Claim 5 or 6, **characterized in that** the inlet opening (12) and/or the outlet opening (13) is provided with a cover (14).

8. The gripping device (1) for a motor vehicle according to one of Claims 5 - 7, **characterized in that** a shield (22) is arranged in the sealed off central receiving space (11) over the carrier (20) with electronic components (21).

9. The gripping device (1) for a motor vehicle according to one of Claims 5 - 8, **characterized in that** the handling base body (10) has a plurality of recesses (15) at its periphery, into which recesses the sealing joint (30) extends.

## Revendications

1. Procédé de fabrication d'un dispositif poignée (1) pour un véhicule automobile, sachant qu'
un corps de base de poignée allongé (10) est préparé avec un compartiment de logement central (11),
des composants de système électronique (21) disposés sur un support (20) sont disposés dans le compartiment de logement central (11),
autour de le compartiment de logement central (11) est appliqué un joint d'étanchéité (30) entourant celui-ci sur le corps de base de poignée allongé (10),
un couvercle de poignée (40) adéquat est disposé sur le corps de base de poignée allongé (10),
sachant que lors de la mise en place du couvercle de poignée (40), le joint d'étanchéité (30) est comprimé de telle manière que le compartiment de logement central (11) est étanchéifié vers l'extérieur par le biais du joint d'étanchéité (30) et une ouverture d'entrée (12) et une ouverture de sortie (13) sont formées aux extrémités opposées de le compartiment de logement central (11),
le dispositif poignée (1) est orienté verticalement de telle manière que l'ouverture d'entrée (12) est disposée vers le bas,
une masse d'étanchéification liquide (50) est versée par l'ouverture d'entrée (12) et remplit de bas en haut le compartiment de logement central (11),
les gaz présents dans le compartiment de logement central (11) lors du remplissage de la masse d'étanchéification (50) sont éliminés par l'ouverture de sortie (13).

2. Procédé de fabrication d'un dispositif poignée (1) pour un véhicule automobile selon la revendication 1, **caractérisé en ce que** le corps de base de poignée allongé (10) est préparé avec deux ouvertures qui forment l'ouverture d'entrée (12) et l'ouverture de sortie (13) lors de la mise en place du couvercle de poignée (40).

3. Procédé de fabrication d'un dispositif poignée (1) pour un véhicule automobile selon la revendication 1 ou 2, **caractérisé en ce que** l'ouverture d'entrée (12) et/ou l'ouverture de sortie (13) sont dotées d'un cache (14) après la prise de la masse d'étanchéification (50).

4. Procédé de fabrication d'un dispositif poignée (1) selon l'une quelconque des revendications 1 - 3, **caractérisé en ce qu'**avant la mise en place du couvercle de poignée (40), un volet de protection (22) est disposé sur les composants du système électronique (21) .

5. Dispositif poignée (1) pour un véhicule automobile avec
un corps de base de poignée allongé (10) et un couvercle de poignée (40), sachant qu'entre le corps de base de poignée (10) et le couvercle de poignée (40) est disposé un joint d'étanchéité (30) qui définit un compartiment de logement (11) fermé central avec le corps de base de poignée (10) et le couvercle de poignée (40),
sachant que dans le compartiment de logement (11) sont placés des composants de système électronique (21) disposés sur un support (20) et une masse d'étanchéification (50) et sachant que le compartiment de logement (11) comporte aux extrémités opposées une ouverture d'entrée (12) et une ouverture de sortie (13), qui peuvent être remplies au moins par endroit d'une masse d'étanchéification.

6. Dispositif poignée (1) pour un véhicule automobile selon la revendication 5, **caractérisé en ce que** le corps de base de poignée (10) comporte l'ouverture d'entrée (12) et/ou l'ouverture de sortie (13).

7. Dispositif poignée (1) pour un véhicule automobile selon la revendication 5 ou 6, **caractérisé en ce que** l'ouverture d'entrée (12) et/ou l'ouverture de sortie (13) sont dotées d'un cache (14).

8. Dispositif poignée (1) pour un véhicule automobile selon l'une quelconque des revendications 5 - 7, **caractérisé en ce qu'**un volet de protection (22) est disposé dans le compartiment de logement central étanchéifié (11) sur le support (20) avec les composants de système électronique (21).

9. Dispositif poignée (1) pour un véhicule automobile selon l'une quelconque des revendications 5 - 8, **caractérisé en ce que** le corps de base de poignée (10) comporte sur sa périphérie une pluralité de cavités (15) dans lesquelles s'étend le joint d'étanchéité (30) .
